# EUROPEAN PATENT APPLICATION

(11) **EP 4 807 996 A1**
(43) Date of publication of application: **16.09.2026**
(21) Application number: 25199558.5
(22) Date of filing: 02.09.2025
(51) Int. Cl.: H03M 7/40, H03M 7/30

(54) **METHODS, SYSTEM AND ELECTRONIC DEVICE FOR NEURAL DATA COMPRESSION, DECOMPRESSION, TRANSMISSION AND RECEPTION**

(30) Priority: 11.03.2025 CN 202510280257
(71) Applicant: Fasikl Incorporated, Dallas, TX 75206 (US); Hangzhou Fasikl Technology Co., Ltd, Hangzhou, Zhejiang 310000 (CN)
(72) Inventor: Nguyen, Jules Anh Tuan, DALLAS, 75206 (US); YANG, Zhi, Hangzhou City (CN)
(74) Representative: Chung, Hoi Kan

(57) **Abstract**

The present disclosure relates to the field of neural data processing, and in particular to methods, a system and an electronic device for neural data compression, decompression, transmission and reception. The neural data compression method includes: preprocessing neural data to achieve code distribution centered around zero; using an autoregressive model to reshape the code distribution of the neural data; and performing entropy coding on the reshaped neural data to obtain compressed data. Through the compression method provided by the present disclosure, data transmission efficiency is enhanced: the preprocessing and the entropy coding can significantly lower storage space and transmission bandwidth requirements for the data. It is particularly important for a neural interface device that produces a large amount of data, and significant advantages exist in both local storage and transmission to a host through a network.

## Description

### CROSS-REFERENCE TO RELATED APPLICATIONS

The application claims priority to Chinese patent application No. 202510280257.5, filed on March 11, 2025, the entire contents of which are incorporated herein by reference.

### TECHNICAL FIELD

The present disclosure relates to the field of neural data processing, and in particular to methods, a system and an electronic device for neural data compression, decompression, transmission and reception.

### BACKGROUND

Significant challenges exist in wireless transmission of massive neural data from a neural interface device to a host. Data must be compressed by a transmitter and decompressed by a receiver to address constraints of low-power wireless communication technologies (such as BLE). An actual maximum data throughput of BLE 5.2 is 1.4 Mbps, and a data rate of 1.9-3.8 Mbps is generated when a previous motor decoder operates 16-32 channels at a 12-bit resolution and a sampling rate of 10 kHz, far exceeding a BLE bandwidth.

Neural data rates can be reduced through data compression, but practical difficulties exist in developing compression algorithms suitable for neural interface devices. Microprocessors in the devices have limited computing power and memory, and hardly support complex compression and decompression. Further, many neural decoding applications require real-time, low-latency transmission, and the compression algorithms that rely on detecting large sequences of repetitive patterns may compromise real-time performance due to latency, thereby necessitating use of low-complexity algorithms that can effectively preserve neural data while reducing computational costs.

The data compression mainly includes lossy compression and lossless compression. The lossy compression sacrifices data integrity for higher compression ratios and is unsuitable for neural data. Neuroscientists have limited understanding of neural information and prefer the lossless data transmission to maintain signal integrity and facilitate analysis and development of improved neural decoding techniques.

The lossless compression further includes statistical coding, dictionary coding, and transform coding. The statistical coding optimizes storage by allocating shorter codes by frequency; the dictionary coding reduces redundancy by creating a dictionary of repetitive sequences for exchange of shorter codes; and the transform coding modifies data representations to enhance compressibility and is usually combined with other techniques. Modern lossless compression schemes, in combination with these techniques, are integrated in files of formats such as ZIP, PNG, and FLAC, but have not been effectively utilized for real-time neural data compression due to high computation and memory requirements.

### SUMMARY

In view of the defects in the prior art, a first objective of the present disclosure is to provide a neural data compression method for real-time transmission of neural data. Compared with algorithms of the prior art, the method can be implemented on a microcontroller, meet bandwidth requirements of Bluetooth Low Energy (BLE), improve a transmission rate, and achieve lossless transmission of neural data.

A second objective of the present disclosure is to provide a neural data decompression method.

A third objective of the present disclosure is to provide a neural data transmission method.

A fourth objective of the present disclosure is to provide a neural data reception method.

A fifth objective of the present disclosure is to provide a neural data acquisition system.

A sixth objective of the present disclosure is to provide an electronic device.

A seventh objective of the present disclosure is to provide a computer-readable medium.

In order to achieve the above objective, the present disclosure adopts a technical solution as follows:

In an aspect, the present disclosure provides a neural data compression method, and the method includes:
preprocessing neural data to achieve code distribution centered around zero;
using an autoregressive model to reshape the code distribution of the neural data; and
performing entropy coding on the reshaped neural data to obtain compressed data.

Preferably, the preprocessing includes:
processing the neural data through one or more filtering units, where the filtering unit may include a downsampling unit, an anti-aliasing filter unit, and a notch filter.

Preferably, the neural data includes a plurality of channel sub-data obtained from a plurality of data channels; and before the autoregressive model is used to reshape the code distribution of the neural data, the following is further implemented:
performing a cross-channel transformation on the neural data to reduce the dependencies between the plurality of the channel sub-data.

Preferably, before the cross-channel transformation is performed, the following is further implemented:
determining whether the predetermined condition exists between the plurality of the channel sub-data, i.e., when the predetermined condition exists, performing the cross-channel transformation, and otherwise, not performing the cross-channel transformation, where the predetermined condition includes high correlation and artifact situations.

Preferably, the cross-channel transformation is completed through a cross-channel formula, and the cross-channel formula is as follows:

$\begin{matrix}{x}_{1}^{′} = \left({x}_{1}+{x}_{2}+⋯+{x}_{n}\right) / n ; \\ {x}_{2}^{′} = \left({x}_{1}-{x}_{2}\right) / 2 ; \\ … \\ {x}_{n}^{′} = \left({x}_{n - 1}-{x}_{n}\right) / 2 ;\end{matrix}$
where {*x*₁*, x*₂*, ..., xₙ*} is data before conversion; and $\left\{{x}_{1}^{′},{x}_{2}^{′},…,{x}_{n}^{′}\right\}$ is data after the conversion.

Preferably, the using the autoregressive model to reshape the code distribution of the neural data specifically includes:
processing each of the channel sub-data in the neural data through an autoregressive transformation formula to reshape the neural data, where the autoregressive transformation formula is as follows:
$x ′ \left[m\right] = x \left[m\right] - {\sum }_{k = 1}^{{N}_{AR}} x \left[m-k\right] ⋅ {a}_{k}$
where *aₖ* is an autoregressive coefficient; *x*[*m*] is data before the reshaping; *x'*[*m*] is data after the reshaping; and *N_{AR}* is an order of the autoregressive model.

Preferably, the autoregressive coefficient is either fixedly set or obtained by sending through a host computer at a predetermined interval.

Preferably, the entropy coding includes Huffman coding, arithmetic coding, and asymmetric numeral coding.

In a further aspect, the present disclosure provides a neural data decompression method, and the method includes:
performing the entropy coding and decoding of the compressed data to obtain pre-decoded data; and
decoding the pre-decoded data through the autoregressive model to obtain neural data.

Preferably, the neural data includes a plurality of channel sub-data obtained from a plurality of data channels; and
after the neural data is obtained, an inverse cross-channel transformation is further performed to obtain the raw neural data; and the inverse cross-channel transformation is completed through an inverse transformation formula, and the inverse transformation formula is as follows:

$\begin{matrix}{x}_{1} = {x}_{1}^{′} + \frac{2 \left(n-1\right)}{n} {x}_{2}^{′} + \frac{2 \left(n-2\right)}{n} {x}_{3}^{′} + ⋯ + \frac{2}{n} {x}_{n}^{′} ; \\ {x}_{2} = {x}_{1} - 2 {x}_{2}^{′} ; \\ … \\ {x}_{n} = {x}_{n - 1} - 2 {x}_{n}^{′} ;\end{matrix}$
where {*x*₁*, x*₂*, ... , xₙ*} is data after inverse transformation; and $\left\{{x}_{1}^{′},{x}_{2}^{′},…,{x}_{n}^{′}\right\}$ is data before the inverse transformation.

Preferably, before the inverse cross-channel transformation is performed, the following is further implemented:
determining whether the predetermined condition exists between the plurality of the channel sub-data, i.e., when the predetermined condition exists, performing the cross-channel transformation, and otherwise, not performing the cross-channel transformation, where the predetermined condition includes high correlation and artifact situations.

In still a further aspect, the present disclosure provides a neural data transmission method, and the method is applied to neural data detection devices, including:
compressing the obtained neural data according to the neural data compression method according to any one of the examples, to obtain compressed data corresponding to the neural data; and
truncating the compressed data to a predetermined number of bytes and transmitting the data wirelessly to the host computer.

Preferably, after the compressed data is obtained, the compressed data is stored in a buffer; and
before the neural data is processed, the following is further included:
when the device operates in a low-latency mode, and when a volume of data in the buffer does not exceed a latency threshold, the data compression is performed normally, otherwise, new neural data samples are discarded.

In still a further aspect, the present disclosure provides a neural data reception method, and the method is applied to the host computer, including:
receiving compressed data wirelessly; and
decoding the compressed data according to the neural data decompression method according to any one of the examples, to obtain neural data.

In still a further aspect, the present disclosure provides a neural data acquisition system, and the system includes:
a neural data acquisition device, which implements the neural data transmission method according to any one of the examples; and
a host computer, which implements the neural data reception method.

In still a further aspect, the present disclosure provides an electronic device, and the device includes:
a memory, where a computer program is stored on the memory; and
a processor, where when the computer program is executed by the processor, the neural data compression method according to any one of the examples, or the neural data decompression method according to any one of the examples, or the neural data transmission method according to any one of the examples, or the neural data reception method is implemented.

In still a further aspect, the present disclosure provides an electronic device storing a computer program, where when the computer program is executed by the processor, the neural data compression method according to any one of the examples, or the neural data decompression method according to any one of the examples, or the neural data transmission method according to any one of the examples, or the neural data reception method is implemented.

Compared with the prior art, the methods, system and electronic device for neural data compression, decompression, transmission and reception provided by the present disclosure have the following beneficial effects:
1. Improved data stability: preprocessing operations (such as distributing the code to zero), to a certain extent, can reduce the impact of noise in the data, and make the data more stable, which is conducive to mining the essential features of the data.
2. Enhanced data transmission efficiency: the preprocessing and the entropy coding can significantly lower storage space and transmission bandwidth requirements for the data. It is particularly important for the neural interface device that produces the large amount of data, and significant advantages exist in both local storage and transmission to a host through a network.
3. Data feature extraction: the autoregressive model is capable of mining the potential sequential pattern in the neural data, enhancing the compressibility of the data, reshaping the code distribution of the neural data, and improving security of the neural data. The redundant information in the data processed by the autoregressive model may be better organized, which is more conducive to subsequent compressions.
4. Data integrity preservation: the entropy coding is a lossless compression technique through which that data can be compressed to a maximum extent without loss of data information. This ensures that original information of the data can be accurately restored during subsequent processing by the host, thereby ensuring the accuracy of analysis and processing.
5. Data privacy protection: in some cases, data compression can be performed for data processing without exposure of the original data, which helps to protect data privacy. For example, in some neural interface applications requiring protection of user privacy, compressed data can be transmitted and analyzed without leaking sensitive information.
6. Data processing efficiency improvement: by preprocessing and compressing the neural data, computational load for data processing can be reduced, and data processing efficiency can be enhanced. This is particularly important for neural interface device applications (such as a brain-computer interface) with high real-time response requirements.

### BRIEF DESCRIPTION OF THE DRAWINGS

FIG. 1 is a flowchart of a neural data compression method provided by the present disclosure.
FIG. 2 is a flowchart of a neural data compression method provided by an example of the present disclosure.
FIG. 3 illustrates an impact of each step of a neural data compression method provided by the present disclosure on time-series data and code distribution.
FIG. 4 illustrates a bit length of each code in a Huffman dictionary provided by the present disclosure.
FIG. 5 illustrates compression ratios corresponding to different orders of an autoregressive model used for a neural data compression method provided by the present disclosure.
FIG. 6 is a flowchart of a neural data decompression method provided by the present disclosure.
FIG. 7 is a flowchart of a neural data transmission method provided by the present disclosure.
FIG. 8 is a flowchart of a neural data transmission method provided by another example of the present disclosure.
FIG. 9 is a flowchart of a neural data reception method provided by the present disclosure.
FIG. 10 is a structural block diagram of a neural data acquisition system provided by the present disclosure.
FIG. 11 is a structural block diagram of a neural data acquisition system provided by an example of the present disclosure.
FIG. 12 illustrates real-time compression ratios in a stream data transmission process provided by the present disclosure.
FIG. 13 illustrates runtime allocated by NRF52840 for compression and decompression provided by the present disclosure.

### DETAILED DESCRIPTIONS OF THE EMBODIMENTS

To make objectives, technical solutions and effects of the present disclosure clearer and more explicit, the present disclosure will be further described in detail with reference to accompanying drawings and specific examples. It should be understood that specific examples described herein are merely used to explain the present disclosure, and are not intended to limit the present disclosure.

Those skilled in the art should understand that the general description above and the detailed description below are exemplary and illustrative specific examples of the present disclosure and are not intended to limit the present disclosure.

Herein, the terms "including", "comprising" or any other variants thereof are intended to cover non-exclusive inclusion, such that a process or method that includes a list of steps not only includes those steps, and but also may include other steps that are not explicitly listed or inherent to such process or method. Similarly, without more limitations, one or more devices or subsystems, elements or structures or assemblies starting with a statement of "comprising... a" do not exclude the presence of other devices or other subsystems, or other elements or other structures, or other assemblies or other devices, or other subsystems or other elements, or other structures or other assemblies, regardless of further limitations. In the entire specification, phrases such as "in one example" or "in another example" and similar words may, but not necessarily, refer to the same example.

Unless otherwise defined, all technical and scientific terms used herein have the same meanings usually understood by those ordinarily skilled in the art to which the present disclosure belongs.

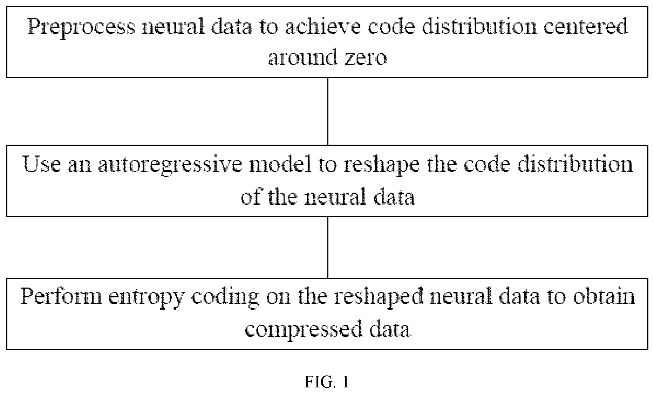

With reference to FIG. 1, the present disclosure provides a neural data compression method, and the method includes:
S1, preprocess neural data to achieve code distribution centered around zero, where the neural data includes several superimposed components, such as a compound action potential (CAP), a neural spike (NS), and a local field potential (LFP), which exhibit different temporal and spectral features. To ensure accurate neural decoding, these features must be preserved through lossless compression.

After a neural interface device generates a large amount of neural data, the neural data need to be preprocessed first to distribute its code to zero. This facilitates subsequent operations, e.g., by distributing the data to a zero-centered range, subsequent model processing (such as an autoregressive model) can be performed within a relatively uniform numerical range, thereby reducing computational complexity caused by an excessively large numerical range. Further, data stability can be improved: code distribution to zero, to a certain extent, can reduce an impact of noise in the data, and make the data more stable, which is conducive to mining essential features of the data.

A specific operation of code distribution to zero can involve normalizing raw neural data, which aims to achieve code distribution centered around zero. For example, assuming that the neural data is encoded based on an amplitude and frequency of electrical signals, values of these signals can be adjusted through a specific algorithm, until a certain statistical magnitude (such as a mean or median) approaches zero.

S2, use the autoregressive model to reshape code distribution of the neural data, where the autoregressive model is a model capable of capturing internal dependencies of a data sequence. In this step, the preprocessed neural data is input into the autoregressive model, to mine a potential sequence pattern in the neural data, which improves compressibility of the data. Redundant information in the neural data processed by the autoregressive model may be better organized, which is more conducive to subsequent compressions. Further, the neural data usually possesses time-series features, the autoregressive model is capable of effectively adapting to the time-series features, and internal logical relationships of the data can be better reflected by adjusting the data distribution.

In a preferred example, the autoregressive model may be based on a neural network, such as a long short-term memory (LSTM) network or a gated recurrent unit (GRU) and the like.

S3, perform entropy coding on the reshaped neural data to obtain compressed data. Specifically, an advantage of the entropy coding lies in that data can be compressed to a maximum extent without loss of data information. Through effective compression of the large amount of data generated by the neural interface device, bandwidth requirements and storage costs of data transmission can be lowered, and efficiency of data transmission and processing can also be improved.

In this example, compression steps for the neural data include data filtering, reshaped coding, and entropy coding. The following beneficial effects may be achieved:
1. Improved data stability: preprocessing operations (such as distributing the code to zero), to a certain extent, can reduce the impact of noise in the data, and make the data more stable, which is conducive to mining the essential features of the data.
2. Enhanced data transmission efficiency: the preprocessing and the entropy coding can significantly lower storage space and transmission bandwidth requirements for the data. It is particularly important for the neural interface device that produces the large amount of data, and significant advantages exist in both local storage and transmission to a host through a network.
3. Data feature extraction: the autoregressive model is capable of mining the potential sequential pattern in the neural data, enhancing the compressibility of the data, reshaping the code distribution of the neural data, and improving security of the neural data. The redundant information in the data processed by the autoregressive model may be better organized, which is more conducive to subsequent compressions.
4. Data integrity preservation: the entropy coding is a lossless compression technique through which that data can be compressed to a maximum extent without loss of data information. This ensures that original information of the data can be accurately restored during subsequent processing by the host, thereby ensuring the accuracy of analysis and processing.
5. Data privacy protection: in some cases, data compression can be performed for data processing without exposure of the original data, which helps to protect data privacy. For example, in some neural interface applications requiring protection of user privacy, compressed data can be transmitted and analyzed without leaking sensitive information.
6. Data processing efficiency improvement: by preprocessing and compressing the neural data, computational load for data processing can be reduced, and data processing efficiency can be enhanced. This is particularly important for neural interface device applications (such as a brain-computer interface) with high real-time response requirements.

As a preferred solution, in this example, the preprocessing includes:
process the neural data through one or more filtering units, where the filtering unit may include a downsampling unit, an anti-aliasing filter unit, and a notch filter. In this example, one or more filters can be integrated and applied to the neural data. Further, when part of the neural data is critical, the anti-aliasing filter and the downsampling unit may be used to reduce a data rate. For example, in practical applications, neural signals sampled at 10 kHz are downsampled to 5 kHz. Next, the notch filter can be used to remove unwanted components, such as a DC offset (0 Hz), a chopping frequency (half of a sampling frequency), and power line interference (50 Hz or 60 Hz). These filters merge the code distribution of the data to zero, thereby improving the compressibility in subsequent stages.

As a preferred solution, in this example, the filter is preferably a digital filter, and when a plurality of digital filters are used for preprocessing, Direct-Form I or II digital filters can be employed for implementation. Further, all the digital filters can be combined into a single filtering operation, where coefficients of a plurality of the digital filters can be combined. For example, when needing to use two digital filters for preprocessing, the Direct-Form II digital filters can be used for implementation:

The first digital filter is an n-order filter, requiring two sets of coefficients, i.e., *a*₁[1,2, *..., n*] and *b*₁[0,1,2, *..., n*]*.*

The second filter is a m-order filter, requiring two sets of coefficients, i.e., *a*₂ [1, 2, ..., *m*] and *b*₂ [0*,* 1*,* 2*, ..., m*]*.*

In this example, based on these coefficients, the two independent digital filters can be combined into a (n + m)-order filter:
$a = {a}_{1} ∗ {a}_{2} ;$ and
*b = b*_{1 *} *b*₂, where _{*} indicates the convolution operation.

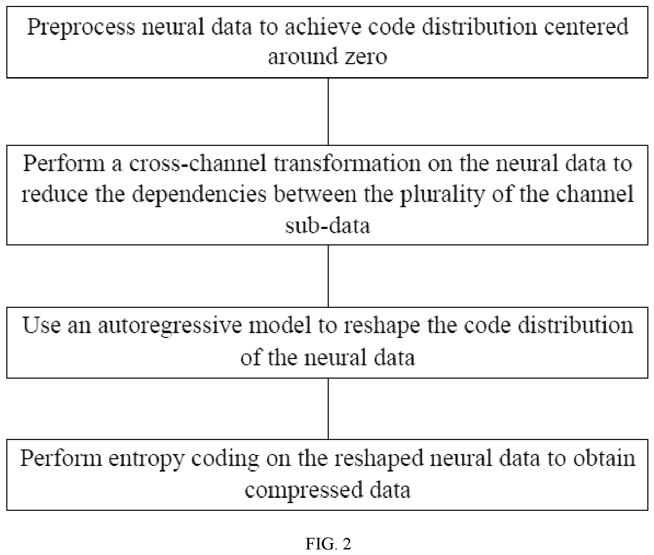

With reference to FIG. 2, as a preferred solution, in this example, the neural data includes a plurality of channel sub-data obtained from a plurality of data channels; and before the autoregressive model is used to reshape the code distribution of the neural data, the following is further implemented:
S1', perform a cross-channel transformation on the neural data to reduce the dependencies between the plurality of the channel sub-data.

That is, in this example, the neural data compression method includes four steps: data preprocessing, cross-channel transformation, code reshaping, and entropy coding. After adding the cross-channel transformation, interference among the plurality of the channel sub-data in the neural data is greatly reduced, which further reduces a data volume and complexity. When the dependencies between the plurality of the channel sub-data are reduced, each channel sub-data can more independently reflect a certain aspect of neural information. This is conducive to more accurately analyzing specific neural signal features carried by each channel. For example, when studying neural activity in different regions of a brain, different channels correspond to different regions of the brain, and when the dependency between the channel sub-data is reduced, neural activity patterns of each region of the brain can be understood more clearly, without interference by signals from other regions of the brain.

Further, after processing of the neural data through the cross-channel transformation, when the autoregressive model is used for processing of the neural data later, training and processing efficiency of the model can be improved by reducing the dependencies between the channel sub-data. For the autoregressive model, reducing the dependency between channel sub-data means that features of input data are more independent, and the model is capable of learning the patterns of sub-data from each channel more easily, reducing the complexity of model training, and improving a convergence speed. For a classification model (such as a support vector machine, a neural network classifier, and the like), the channel sub-data with enhanced independence can provide clearer classification features, which improves classification accuracy and efficiency.

Moreover, during the data compression, the channel sub-data with low dependency can be compressed separately more easily. For example, during the entropy coding, when the channel sub-data are highly dependent, their joint probability distribution will be complex, and efficient compression is difficult. However, when the dependencies are reduced, each channel sub-data can be entropy-encoded more effectively according to its own probability distribution, thereby improving an overall data compression ratio. For example, in previous work, subsets of 8 out of 16 channels share a same negative input and records from a same nerve bundle, and therefore, we applied the cross-channel transformation to each subset of the 8 channels.

As a preferred solution, in this example, when a predetermined condition exists between the plurality of the channel sub-data, the following is further implemented before performing the cross-channel transformation:

Determine whether the predetermined condition exists between the plurality of the channel sub-data, i.e., when the predetermined condition exists, perform the cross-channel transformation, and otherwise, do not perform the cross-channel transformation, where the predetermined condition includes high correlation and artifact situations.

Further, to achieve more flexible processing of the neural data, the cross-channel transformation will not be performed when the predetermined condition does not exist between the plurality of the channel sub-data. A method for determining whether the predetermined condition exists can include data correlation detection (a detection method commonly used in the art), or correlation selection by a user in advance. For example, the user can select high correlation and low correlation modes corresponding to different compression processes.

As a preferred solution, in this example, the cross-channel transformation is completed through a cross-channel formula, and the cross-channel formula is as follows:

$\begin{matrix}{x}_{1}^{′} = \left({x}_{1}+{x}_{2}+⋯+{x}_{n}\right) / n ; \\ {x}_{2}^{′} = \left({x}_{1}-{x}_{2}\right) / 2 ; \\ … \\ {x}_{n}^{′} = \left({x}_{n - 1}-{x}_{n}\right) / 2 ;\end{matrix}$ where {*x*₁*, x*₂*, ..., xₙ*} is data before conversion; and $\left\{{x}_{1}^{′},{x}_{2}^{′},…,{x}_{n}^{′}\right\}$ is data after the conversion, ${x}_{1}^{′}$ in $\left\{{x}_{1}^{′},{x}_{2}^{′},…,{x}_{n}^{′}\right\}$ denotes a common signal captured, and other items represent captured differential signals.

As a preferred solution, in this example, the using the autoregressive model to reshape the code distribution of the neural data specifically includes:
process each of the channel sub-data in the neural data through an autoregressive transformation formula to reshape the neural data, where the autoregressive transformation formula is as follows:
   $x ′ \left[m\right] = x \left[m\right] - {\sum }_{k = 1}^{{N}_{AR}} x \left[m-k\right] ⋅ {a}_{k}$
where *aₖ* is an autoregressive coefficient; *x*[*m*] is data before the reshaping; *x'*[*m*] is data after the reshaping; and *N_{AR}* is an order of the autoregressive model.

As a preferred solution, in this example, the autoregressive coefficient is either fixedly set or obtained by sending through a host computer at a predetermined interval.

In some examples, the autoregressive coefficient is fixedly set by a neural data acquisition device and the host computer, and in this case, the autoregressive coefficient remains unchanged, a set of default autoregressive coefficients are used for the autoregressive model, and these autoregressive coefficients are pre-calculated based on past neural data recorded by a same device under similar configurations.

In some examples, the autoregressive coefficient is adaptive, and in this case, to optimize the compression ratio, the host computer can periodically recalculate the autoregressive coefficient at a fixed interval during operation according to received data, and then the updated coefficient will be sent back to the device and can be adjusted separately for each channel. As computational resources of the neural data acquisition device are limited, the device does not compute the coefficients by itself. This adaptive method allows a compression pipeline to respond to changes in data features with a minimal device processing load.

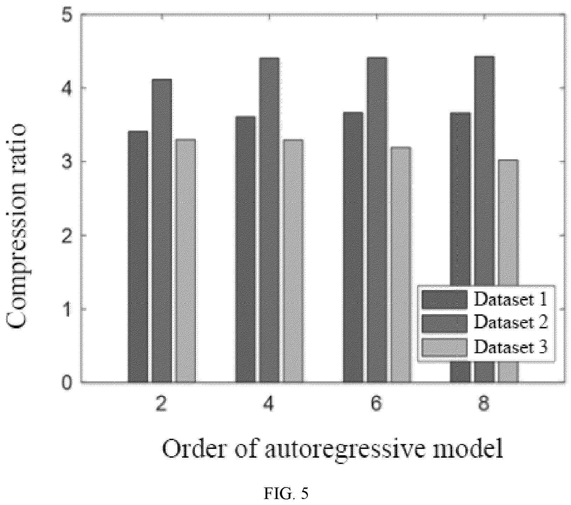

FIG. 5 illustrates compression ratio results obtained by processing different data with different orders of the autoregressive (AR) model according to the neural data compression method provided by the present disclosure, and the number of orders ranges from 2 to 8. In an evaluation process, historical sample datasets are used, the datasets are obtained from different experimental devices, electrode types and recording configurations, and all the datasets are processed separately according to the neural data compression method provided by the present disclosure. Among them, a dataset 1 consists of peripheral nerve data of amputees recorded through intrafascicular microelectrodes; a dataset 2 consists of peripheral nerve data and EMG data of healthy participants' wrists recorded through surface electrodes; and a dataset 3 consists of data of neural signals of patients with Parkinson's disease recorded through deep brain stimulation (DBS) probes during active stimulation. Results indicate that the proposed method consistently achieves the compression ratio ranging between 3 and 5.

As a preferred solution, in this example, the entropy coding includes Huffman coding, arithmetic coding, and asymmetric numeral coding. Further, the entropy coding is preferably the Huffman coding.

The final step of the compression method provided by the present disclosure is the entropy coding for achieving data compression. This can be efficiently implemented on a microcontroller. Although the entropy coding is the only step for implementing data reduction, compression effectiveness largely depends on the code distribution of the data, and the code distribution of the neural data is processed or reshaped through the preceding preprocessing, the cross-channel transformation, and the processing by the autoregressive model, thereby ensuring a high compression ratio.

Table 1 compares the compression ratios obtained according to the neural data compression method provided by the present disclosure and lossless compression schemes (including BZIP2, LZMA, Deflate, and PPMD). An optimized set of AR coefficients and a Huffman dictionary are used for each dataset. The method provided herein achieves the compression ratio ranging between 3.7 and 4.4, outperforming all other schemes. The method of outstanding performance is advantageous due to special optimization of the neural data, which is different from other algorithms designed for general data types.

**Table 1 Comparison results of compression ratios obtained according to the neural data compression method provided by the present disclosure and the lossless compression schemes of the prior art**

| Dat aset | Neural recordin g mode | Stim ulus artifa ct | Num ber of chan nels | Samp ling rate (kHz) | Da ta siz e (M B) | Propos ed compre ssion ratio | BZIP2 compre ssion ratio | LZMA compre ssion ratio | Deflate compre ssion ratio | PPMD compre ssion ratio |
|---|---|---|---|---|---|---|---|---|---|---|
| 1 | Intrafasc icular peripher al nerves | No | 16 | 10 | 58 6 | 3.67 | 2.06 | 2.21 | 1.81 | 2.27 |
| 2 | Non-invasive nerves and muscles | No | 16 | 20 | 22 8 | 4.42 | 2.22 | 2.4 | 1.95 | 2.42 |
| 3 | DBS | Yes | 10 | 20 | 17 1 | 3.3 | 2.14 | 2.21 | 1.8 | 2.34 |

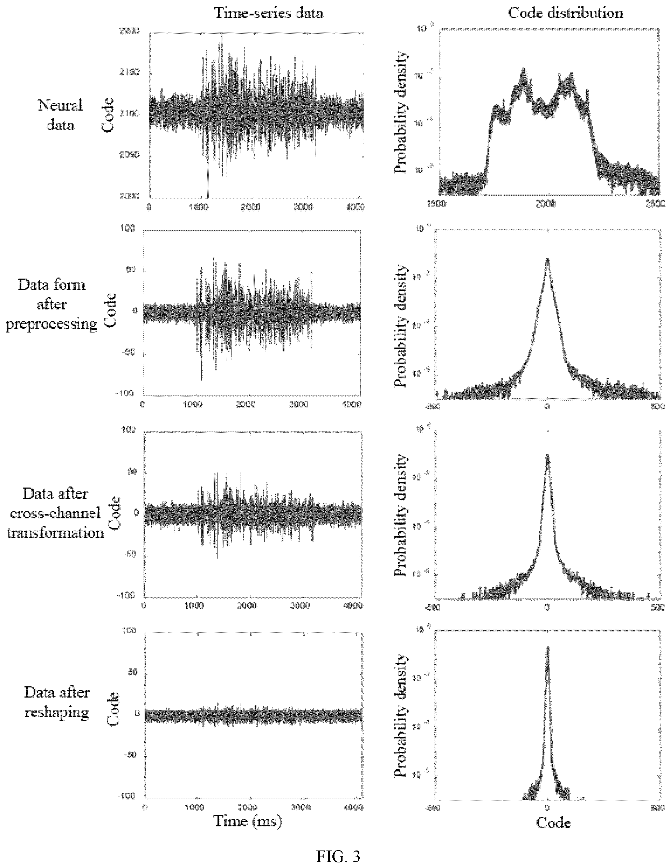

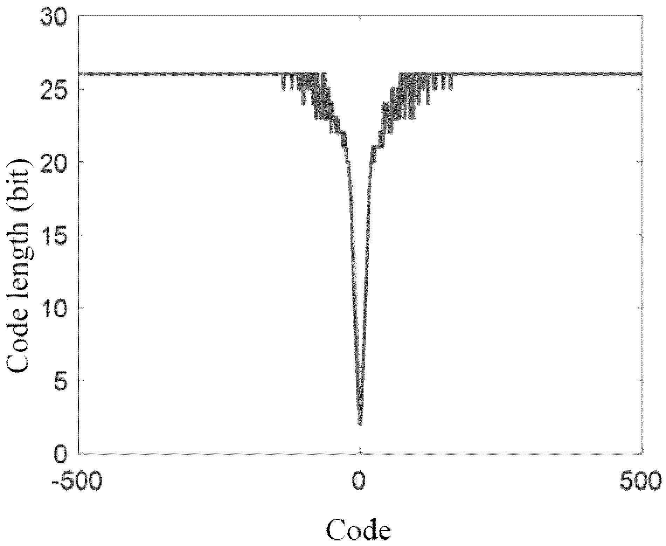

FIG. 3 illustrates evolution of the code distribution after each step, and FIG. 4 illustrates a bit length assigned to each code in the Huffman dictionary. Any compression results are not produced in the steps of the preprocessing, the cross-channel transformation, and the processing by the autoregressive model, but they will fundamentally reshape the code distribution of the data, and progressively concentrate the code distribution of each stage until zero. As the code distribution becomes more concentrated, the compression ratio achievable in the final step of the Huffman coding (the Huffman coding is used as the entropy coding in this example) is higher. The Huffman dictionary is pre-estimated based on previous datasets recorded by a same neural interface device under same configuration conditions. Throughout normal operation, this dictionary remains fixed on both the host computer and the neural data acquisition device.

The neural data compression method provided by the present disclosure has significant advantages in processing neural signal data. The autoregressive (AR) model is utilized and coefficients of the model are periodically recalculated to adapt to dynamic features of neural signals, so as to ensure sustained compression efficiency. In terms of compression effect, the compression ratio ranging between 3.7 and 4.4 is achieved, indicating that the method is relatively effective in compressing the neural data. For example, an initial data rate of raw neural data is 3.8 million bits per second (3.8 Mbps). Data of this rate cannot be transmitted via BLE, as it exceeds a maximum throughput of 1.4 million bits per second (1.4 Mbps) for the BLE. After processing of the raw neural data through the data compression method provided by the present disclosure, the data rate becomes 3.8 ÷ 4 (taking the compression ratio of 4 as an example) = 0.95 Mbps, and in this case, the BLE can be used for data transmission.

The following table summarizes computational complexity and memory complexity of each step in the neural data compression method provided by the present disclosure.

**Table 2 Results of computational complexity and memory complexity of each step in the neural data compression method**

| Stage step | Name | Computational complexity | Storage complexity |
|---|---|---|---|
| 1 | Data filtering | *O*(*N_{F}*) | *O*(*N_{F} · N_{CH}*) |
| 2 | Cross-channel transformation | *O*(*N_{CH}*) | *O*(*N_{CH}*) |
| 3 | Predictive coding of AR model | *O*(*N_{AR}*) | *O*(*N_{AR} · N_{CH}*) |
| 4 | Huffman coding | *O*(log *N*_{C}) | *O*(*N_{C}*) |

| | | | |
|---|---|---|---|
| *O*(_{*}) denotes computational complexity, *N_{F}* is an order of filter, preferably 4-8; *N_{CH}* is a channel number, preferably 16-32; *N_{AR}* is an order of AR model, preferably 3-10; and *N_{C}* is the number of different codes, preferably 2⁸-2¹². As shown in Table 2, computational complexity of the data compression method provided by the present disclosure is relatively low, and the method can be implemented on a microcontroller. | | | |

Table 2 summarizes complexities associated with each stage of a proposed compression scheme. Several advantages of the proposed method suitable for the neural interface applications are highlighted:
1. Computationally friendliness: computational efficiency at each step of an assembly line is designed to be high, which can be implemented on a low-power microcontroller with linear time complexity or a faster rate.
2. Efficient storage: each step only requires storage of minimally a few previous samples, and the method applies to low-power microcontrollers, where RAM of each of the microcontrollers is usually less than 1 MB.
3. Low latency: input data is processed, transmitted, and received sample by sample without need to wait for long-sequence data. This is crucial for real-time neural decoding applications, which ensures minimal latency from data acquisition to neural decoder interpretation.

Moreover, the method features the low computational complexity and memory complexity, such that the method can be implemented on the low-power microcontrollers. A NRF52840 system-on-chip (SoC) is used for prototype neural interface validation. This chip acquires data from 16 neural data channels at a sampling rate of 10 kHz and subsequently achieves stream transmission of the data to the host computer through a BLE 5.2 data link. During data transmission, a neural data acquisition system is capable of maintaining the compression ratio of 3.5 and a data throughput of 220 kbps, such that real-time and lossless transmission of neural signals with minimal latency can be achieved.

The neural data compression method provided by the present disclosure is of great significance to neural prosthesis control, and particularly provides strong support for development of wireless peripheral nerve interfaces. Use of Bluetooth Low Energy (BLE) technology ensures reliable real-time data transmission from the neural interface to the neural decoder, which lays a solid foundation for precise control of neural prostheses, and has broad prospects of application in fields such as neuroscience research, neural prosthesis and the like.

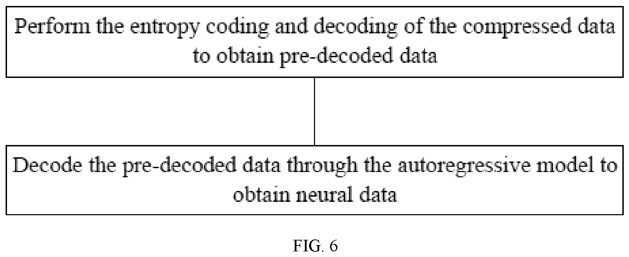

Accordingly, with reference to FIG. 6, the present disclosure further provides a neural data decompression method, and the method includes:
perform the entropy coding and decoding of the compressed data to obtain pre-decoded data; and
decode the pre-decoded data through the autoregressive model to obtain neural data.

Specifically, in contrast to a neural data compression step, after the host computer receives the compressed data, the compressed data is decoded back to original data through a same dictionary (a coding dictionary corresponding to the entropy coding). Next, the same autoregressive model is applied for inverse processing to obtain the neural data by decoding.

Of course, in some examples, the autoregressive coefficients used for the autoregressive model of the neural data decompression method may be recalculated and generated at a predetermined interval, and after new autoregressive coefficients are generated, the host computer will maintain consistency in the autoregressive coefficients between the host computer and the neural data acquisition device via data transmission.

As a preferred solution, in this example, the neural data includes a plurality of channel sub-data obtained from a plurality of data channels; and
after the neural data is obtained, an inverse cross-channel transformation is further performed to obtain the raw neural data; and the inverse cross-channel transformation is completed through an inverse transformation formula, and the inverse transformation formula is as follows:

$\begin{matrix}{x}_{1} = {x}_{1}^{′} + \frac{2 \left(n-1\right)}{n} {x}_{2}^{′} + \frac{2 \left(n-2\right)}{n} {x}_{3}^{′} + ⋯ + \frac{2}{n} {x}_{n}^{′} ; \\ {x}_{2} = {x}_{1} - 2 {x}_{2}^{′} ; \\ ⋯ \\ {x}_{n} = {x}_{n - 1} - 2 {x}_{n}^{′} ;\end{matrix}$
where {*x*₁*, x*₂*, ..., xₙ*} is data after the inverse transformation; and $\left\{{x}_{1}^{′},{x}_{2}^{′},…,{x}_{n}^{′}\right\}$ is data before the inverse transformation.

As a preferred solution, in this example, before the inverse cross-channel transformation is performed, the following is further implemented:
determine whether the predetermined condition exists between the plurality of the channel sub-data, i.e., when the predetermined condition exists, perform the cross-channel transformation, and otherwise, do not perform the cross-channel transformation, where the predetermined condition includes high correlation and artifact situations.

In this example, the neural data acquisition device sends a data identifier to determine whether the cross-channel transformation of transmitted data is completed.

Specifically, in view that in the neural data compression step, unwanted components have been removed from the neural data through a filter, and a neural data decompression process provided by the present disclosure does not include a filtering step, thereby simplifying a decompression step and improving processing efficiency.

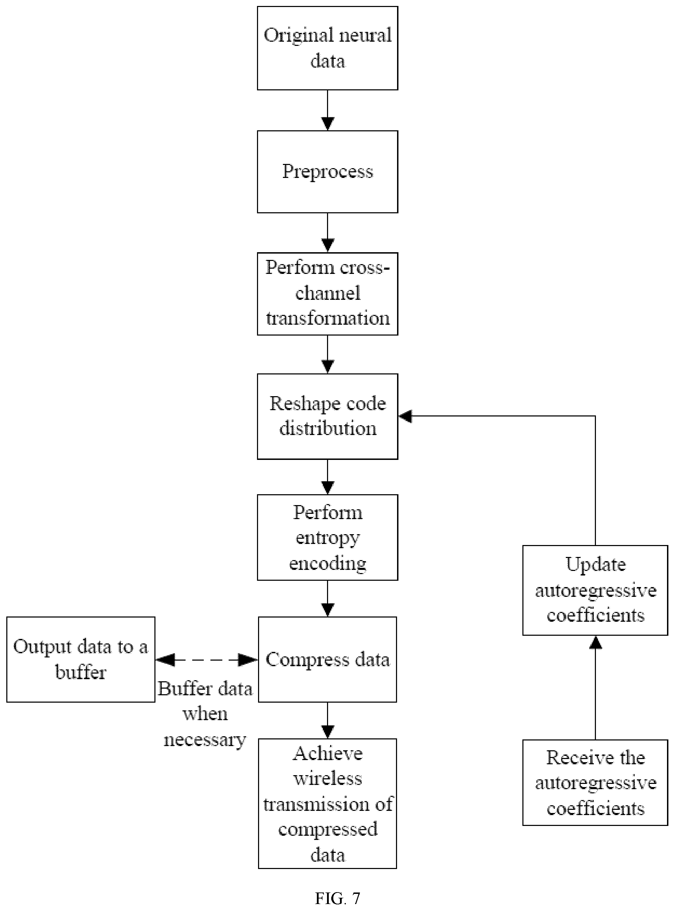

Accordingly, with reference to FIG. 7, the present disclosure further provides a neural data transmission method, and the method is applied to neural data detection devices, including:
compress the obtained neural data according to the neural data compression method according to any one of the above examples, to obtain compressed data corresponding to the neural data; and
truncate the compressed data to a predetermined number of bytes and transmit the data wirelessly to the host computer. For example, a compressed data stream generated (such as a bitstream) is truncated into 8-bit bytes and transmitted wirelessly to the host computer.

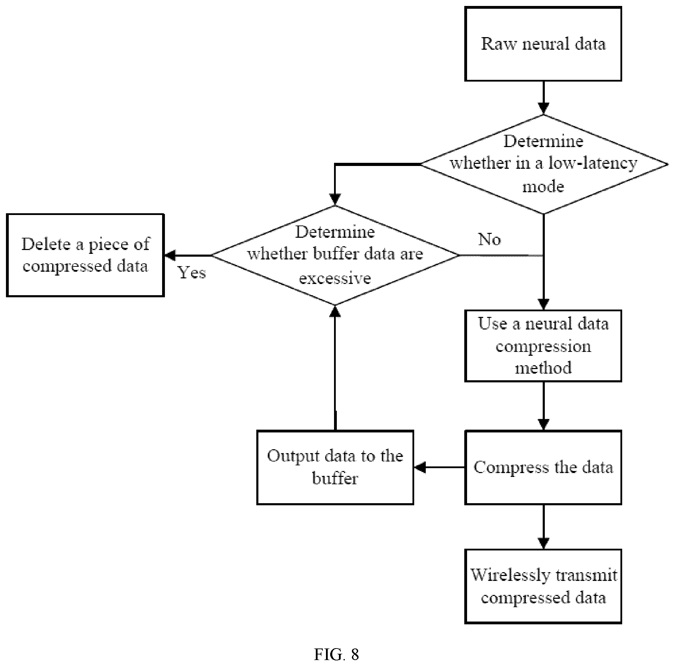

With reference to FIG. 8, as a preferred solution, in this example, after the compressed data is obtained, the compressed data is stored in a buffer to prevent data loss during real-time transmission due to changes in the compression ratio.

Before the neural data is processed, the following is further included:
When the device operates in a low-latency mode, and when a volume of data in the buffer does not exceed a latency threshold, the data compression is performed normally, otherwise, new neural data samples are discarded. Here, the data sample represents compressed neural data obtained by processing at one time point.

Of course, in some examples, when the device is in the low-latency mode and the volume of data in the buffer exceeds the latency threshold, a compression process of new neural data will no longer be processed.

The low-latency mode: the proposed pipeline can operate in either a normal mode or the low-latency mode. During data streaming, an interruption in a BLE connection may temporarily reduce the data throughput. The low-latency mode shown in FIG. 8 is specially designed for time-sensitive applications, i.e., under the low-latency mode, a user can control the neural prosthesis in real time. In this case, any backlog in the buffer may introduce unacceptable lag in repair control. For effective management, the system will continuously monitor data loads of the buffer. When the data load exceeds a predefined threshold associated with an allowable latency, the system will begin to discard data samples from all channels. This process will continue until the BLE connection is restored and the load of the buffer returns to an acceptable level.

In the normal mode, a larger output data buffer is used to prevent data loss, and the mode is suitable for non-time-critical applications, such as collection of training data.

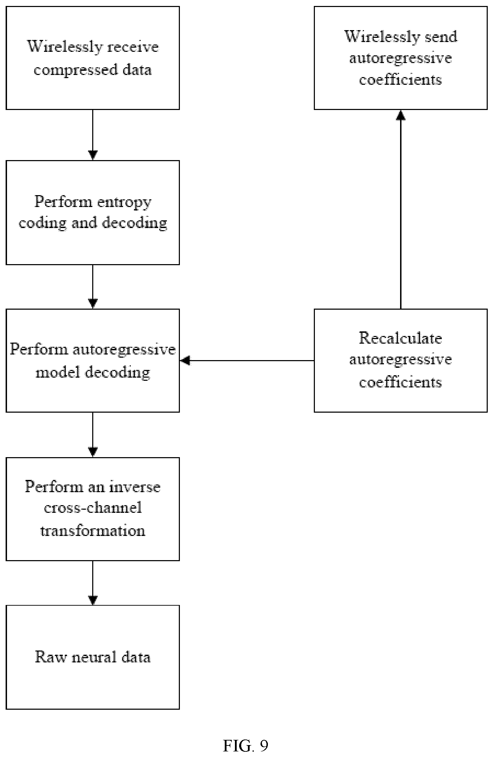

Accordingly, with reference to FIG. 9, the present disclosure further provides a neural data reception method, and the method is applied to the host computer, including:
receive compressed data wirelessly; and
decode the compressed data according to the neural data decompression method according to any one of the above examples, to obtain neural data.

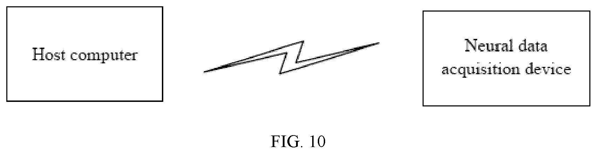

Accordingly, with reference to FIGs. 10-11, the present disclosure further provides a neural data acquisition system, and the system includes:
a neural data acquisition device, which implements the neural data transmission method according to any one of the above examples; and
a host computer, which implements the neural data reception method according to any one of the above examples. The host computer recalculates the autoregressive coefficient at a predetermined interval according to latest data and wirelessly transmits the updated autoregressive coefficient to the neural data acquisition device. Upon receiving a new autoregressive coefficient, the neural data acquisition device will delete an old autoregressive coefficient and update with the autoregressive coefficient received.

Preferably, the host computer is a host device, such as a personal computer (PC), a mobile smart device or the like.

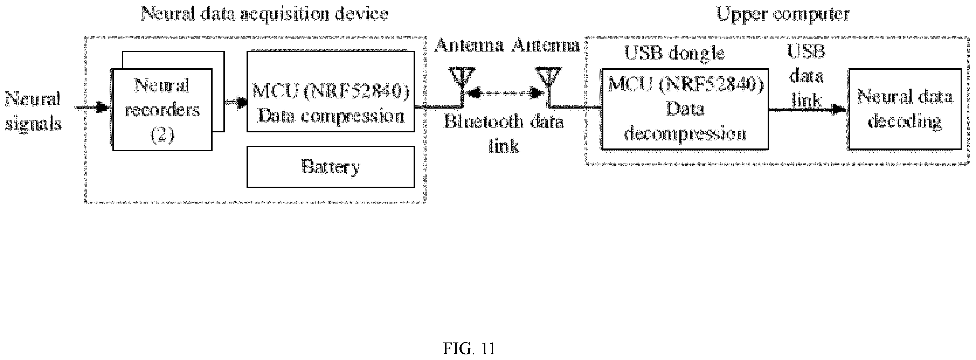

FIG. 11 illustrates an overall architecture of the system. The neural data acquisition device is provided with two Neuronix neural recording chips, and a total of 16 data channels are generated at the sampling rate of 10 kHz and a resolution of 12 bits. The NRF52840 SoC facilitates data compression and the BLE 5.2 data link, including an ARM Cortex-M4 microprocessor operating at 64 MHz and 250 kB of RAM. The compressed data is transmitted to a receiver with a same SoC configuration. Hardware of the receiver is an NRF5290 USB dongle, and the dongle performs data decompression and then sends uncompressed data to a computer via a USB data link for neural decoding.

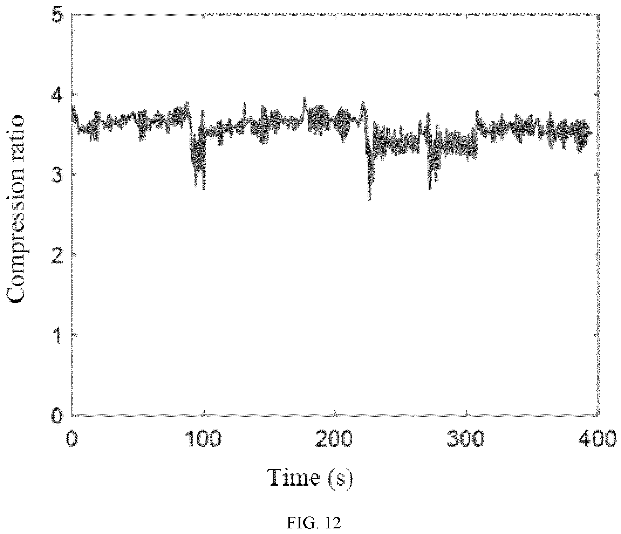

With reference to FIG. 12, real-time compression ratios are shown, and the real-time compression ratio is calculated every second over a 7-minute sample of neural data. The compression ratio remains stable at about 3.5 with minimal fluctuations, and the data throughput is 220 kbps. Such arrangement enables to provide a substantial data throughput overhead (at most 1.4 Mbps), thereby ensuring reliable performance even in the event of connection interruptions during actual experiments.

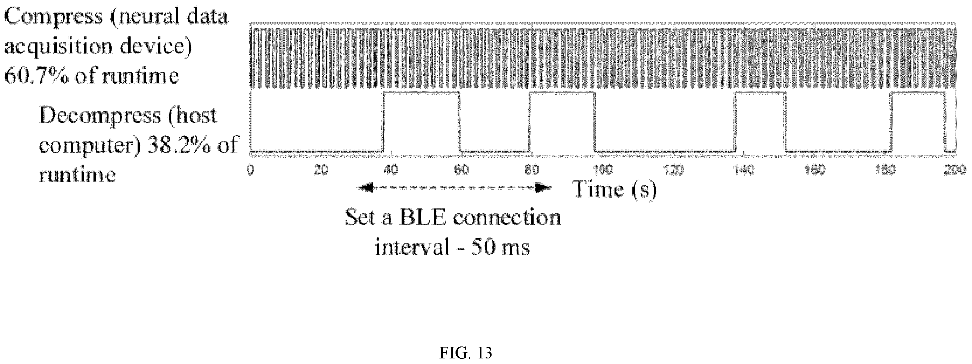

FIG. 13 illustrates runtime allocation for processes of compression and decompression on the NRF52840 SoC. Runtime of compression on the neural data acquisition device side accounts for 60%, and that of decompression on the host computer side accounts for 38%. Data packets are compressed every 2 ms, which keeps consistent with data transmission between a neural chip and a microcontroller. Received data packets are decompressed every 50 ms, which matches a BLE connection interval. It can be seen that the data compression method provided by the present disclosure can be implemented normally on the microcontroller.

Accordingly, the present disclosure further provides an electronic device, and the device includes:
a memory, where a computer program is stored on the memory; and
a processor, where when the computer program is executed by the processor, the neural data compression method according to any one of the above examples, or the neural data decompression method according to any one of the above examples, or the neural data transmission method according to any one of the above examples, or the neural data reception method is implemented.

Accordingly, the present disclosure further provides an electronic device that is preferably a computer-readable medium storing a computer program, where when the computer program is executed by the processor, the neural data compression method according to any one of the above examples, or the neural data decompression method according to any one of the above examples, or the neural data transmission method according to any one of the above examples, or the neural data reception method is implemented.

More specific examples of the computer-readable storage media can include, but are not limited to: an electrical connection with one or more wires, a portable computer disk, a hard drive, a random access memory (RAM), a read-only memory (ROM), an erasable programmable read-only memory (EPROM or flash), optical fibers, a portable compact disc read-only memory (CD-ROM), an optical storage device, a magnetic storage device, or any appropriate combination of the above.

In the present disclosure, the computer-readable storage medium can be any tangible medium that contains or stores a program, and the program can be for use by or in combination with an instruction execution system, device or component. In the present disclosure, a computer-readable signal medium may include a data signal transmitted in a baseband or transmitted as part of a carrier wave, which carries computer-readable program codes. Such transmitted data signals may exist in many forms, including but not limited to electromagnetic signals, optical signals, or any appropriate combination of the above.

It is understood that those of ordinary skill in art may make equivalent substitutions or modifications based on the technical solution and inventive concept of the present disclosure, and all such modifications or substitutions should fall within the scope of protection of the claims of the present disclosure.

## Claims

1. A neural data compression method, comprising:
preprocessing neural data to achieve code distribution centered around zero;
using an autoregressive model to reshape the code distribution of the neural data; and
performing entropy coding on the reshaped neural data to obtain compressed data.

2. The neural data compression method according to claim 1, wherein the preprocessing comprises:
processing the neural data through one or more filtering units, wherein the filtering unit may comprise a downsampling unit, an anti-aliasing filter unit, and a notch filter.

3. The neural data compression method according to claim 1, wherein the neural data comprises a plurality of channel sub-data obtained from a plurality of data channels; and before the autoregressive model is used to reshape the code distribution of the neural data, the following is further implemented:
performing a cross-channel transformation on the neural data to reduce the dependencies between the plurality of the channel sub-data.

4. The neural data compression method according to claim 3, wherein the following is further implemented before performing the cross-channel transformation:
determining whether a predetermined condition exists between the plurality of the channel sub-data, i.e., when the predetermined condition exists, performing the cross-channel transformation, and otherwise, not performing the cross-channel transformation, wherein the predetermined condition comprises high correlation and artifact situations.

5. The neural data compression method according to claim 3, wherein the cross-channel transformation is completed through a cross-channel formula, and the cross-channel formula is as follows: $\begin{matrix}{x}_{1}^{′} = \left({x}_{1}+{x}_{2}+⋯+{x}_{n}\right) / n ; \\ {x}_{2}^{′} = \left({x}_{1}-{x}_{2}\right) / 2 ; \\ … \\ {x}_{n}^{′} = \left({x}_{n - 1}-{x}_{n}\right) / 2 ;\end{matrix}$ in the formulas, {*x₁, x₂, ... , xₙ*} is data before conversion; and $\left\{{x}_{1}^{′},{x}_{2}^{′},…,{x}_{n}^{′}\right\}$ is data after the conversion.

6. The neural data compression method according to claim 3, wherein the using the autoregressive model to reshape the code distribution of the neural data comprises:
processing each of the channel sub-data in the neural data through an autoregressive transformation formula to reshape the neural data, wherein the autoregressive transformation formula is as follows: $x ′ \left[m\right] = x \left[m\right] - {\sum }_{k = 1}^{{N}_{AR}} x \left[m-k\right] ⋅ {a}_{k}$
in the formula, *aₖ* is an autoregressive coefficient; *x*[*m*] is data before the reshaping; x'[m] is data after the reshaping; and *N_{AR}* is an order of the autoregressive model.

7. The neural data compression method according to claim 6, wherein the autoregressive coefficient is either fixedly set or obtained by sending through a host computer at a predetermined interval.

8. The neural data compression method according to claim 1, wherein the entropy coding comprises Huffman coding, arithmetic coding, and asymmetric numeral coding.

9. A neural data decompression method, comprising:
performing the entropy coding and decoding of the compressed data to obtain pre-decoded data; and
decoding the pre-decoded data through the autoregressive model to obtain neural data.

10. The neural data decompression method according to claim 9, wherein the neural data comprises a plurality of channel sub-data obtained from a plurality of data channels;
after the neural data is obtained, an inverse cross-channel transformation is further performed to obtain raw neural data; and the inverse cross-channel transformation is completed through an inverse transformation formula, and the inverse transformation formula is as follows: $\begin{matrix}{x}_{1} = {x}_{1}^{′} + \frac{2 \left(n-1\right)}{n} {x}_{2}^{′} + \frac{2 \left(n-2\right)}{n} {x}_{3}^{′} + ⋯ + \frac{2}{n} {x}_{n}^{′} ; \\ {x}_{2} = {x}_{1} - 2 {x}_{2}^{′} ; \\ ⋯ \\ {x}_{n} = {x}_{n - 1} - 2 {x}_{n}^{′} ;\end{matrix}$
in the formulas, {*x₁, x₂, ... , xₙ}* is data after the inverse transformation; and $\left\{{x}_{1}^{′},{x}_{2}^{′},…,{x}_{n}^{′}\right\}$ is data before the inverse transformation.

11. The neural data decompression method according to claim 10, wherein before the inverse cross-channel transformation is performed, the following is further implemented:
determining whether the predetermined condition exists between the plurality of the channel sub-data, i.e., when the predetermined condition exists, performing the cross-channel transformation, and otherwise, not performing the cross-channel transformation, wherein the predetermined condition comprises high correlation and artifact situations.

12. A neural data transmission method, applied to neural data detection devices, comprising:
compressing the obtained neural data according to the neural data compression method according to claim 1, to obtain compressed data corresponding to the neural data; and
truncating the compressed data to a predetermined number of bytes and transmitting the data wirelessly to the host computer.

13. The neural data transmission method according to claim 12, wherein after the compressed data is obtained, the compressed data is stored in a buffer;
before the neural data is processed, the following is further comprised:
when the device operates in a low-latency mode, and when a volume of data in the buffer does not exceed a latency threshold, the data compression is performed normally, otherwise, new neural data samples are discarded.

14. A neural data reception method, applied to the host computer, comprising:
receiving compressed data wirelessly; and
decoding the compressed data according to the neural data decompression method according to claim 9, to obtain neural data.
